# EUROPÄISCHE PATENTSCHRIFT

(11) **EP 3 093 371 B1**
(45) Veröffentlichungstag und Bekanntmachung des Hinweises auf die Patenterteilung: **15.08.2018**
(21) Anmeldenummer: 16164629.4
(22) Anmeldetag: 11.04.2016
(51) Int. Cl.: C25D 11/34, C25D 15/00, F01D 11/12, F01D 5/28, C23C 14/32, C23C 14/58, C25D 9/06, C25D 5/40, C23C 14/02, C23C 28/00

(54) **KOMBINATION VON SCHAUFELSPITZENPANZERUNG UND EROSIONSSCHUTZSCHICHT SOWIE VERFAHREN ZUR HERSTELLUNG DERSELBEN**
COMBINATION OF ARMOR PLATING FOR A BLADE TIP AND EROSION RESISTANT COATING AND METHOD FOR PRODUCING THE SAME
COMBINAISON DE BLINDAGE D'EXTREMITE D'AUBES ET DE COUCHE DE PROTECTION CONTRE L'EROSION ET SON PROCEDE DE FABRICATION

(30) Priorität: 12.05.2015 DE 102015208781
(43) Veröffentlichungstag der Anmeldung: 16.11.2016
(73) Patentinhaber: MTU Aero Engines AG, 80995 München (DE)
(72) Erfinder: Uihlein, Thomas, 85221 Dachau (DE); Linska, Josef, 85567 Grafing (DE); Stolle, Ralf, 82515 Wolfratshausen (DE)

(56) Entgegenhaltungen:
- EP-A1- 2 316 988
- DE-A1-102005 011 011
- JP-A- H1 030 403
- US-A1- 2003 183 529
- US-B1- 6 434 876

## Beschreibung

### GEBIET DER ERFINDUNG

Die vorliegende Erfindung betrifft ein Verfahren zur Herstellung einer Schaufel für eine Strömungsmaschine, wobei die Schaufel an ihrer Schaufelspitze eine Schaufelspitzenpanzerung und zumindest an ihrem Schaufelblatt eine Erosionsschutzschicht aufweist. Darüber hinaus betrifft die vorliegende Erfindung eine entsprechende Schaufel für eine Strömungsmaschine, wie beispielsweise eine stationäre Gasturbine oder ein Flugtriebwerk.

### STAND DER TECHNIK

Strömungsmaschinen, wie stationäre Gasturbinen oder Flugtriebwerke, weisen unter anderem eine Vielzahl von Schaufeln auf, die an einem Rotor drehbar angeordnet sind, um entweder das Fluid, welches durch die Strömungsmaschine fließt, zu verdichten oder durch das Fluid zur Drehung angetrieben zu werden.

Um die Strömungsverluste zwischen den sich drehenden Schaufeln und einer umgebenden Strömungskanalbegrenzung zu minimieren, muss der Spalt zwischen den Schaufeln und der Strömungskanalbegrenzung möglichst klein sein, sodass möglichst wenig Fluid durch den Spalt zwischen Strömungskanalbegrenzung und Schaufeln fließen kann.

Aus diesem Grund werden bei bekannten Strömungsmaschinen zur Abdichtung zwischen den Schaufelspitzen und der Strömungskanalbegrenzung sogenannte Labyrinthdichtungen vorgesehen, bei welchen die Schaufelspitzen sich in einer Nut bewegen, die sich beim Betrieb der Strömungsmaschine in einem Dichtungsmaterial an der Strömungskanalbegrenzung durch entsprechendes Einschleifen der Schaufelspitzen ausbildet. Entsprechend ist es auch bekannt an den Schaufelspitzen so genannte Schaufelspitzenpanzerungen vorzusehen, die in einer Metall - Matrix eingelagerte Hartstoffpartikel aufweisen, um mittels der Hartstoffpartikel die Nut für die Labyrinthdichtung im gegenüberliegenden Dichtungsmaterial der Strömungskanalbegrenzung einzuschneiden und die Schaufelspitze vor Verschleiß zu schützen.

Darüber hinaus umfassen Schaufeln von Strömungsmaschinen zusätzlich am Schaufelblatt Schutzbeschichtungen, wie Erosionsschutzschichten, um das Schaufelmaterial im Bereich des Schaufelblatts ebenfalls vor Verschleiß, beispielsweise durch Erosion, zu schützen.

Entsprechend ist es erforderlich, an einer Schaufel für eine Strömungsmaschine unterschiedliche Beschichtungen nebeneinander anzuordnen, wie beispielsweise eine Spitzenpanzerung an den Schaufelspitzen und eine Erosionsschutzbeschichtung am Schaufelblatt, wobei jedoch vermieden werden muss, dass eine der Beschichtungen und insbesondere die Schaufelspitzenpanzerung von der anderen Beschichtung, nämlich der Erosionsschutzschicht, überdeckt wird, da die überdeckte Schicht, also z.B. die Schaufelspitzenpanzerung, dann ihre Funktion nicht mehr in der gewünschten Art und Weise erfüllen kann. Vielmehr kann es beim Versagen der Schneidfunktion der Schaufelspitzenpanzerung zu massiven Schaufelbeschädigungen durch zu hohe thermische und mechanische Lasten kommen.

Entsprechend müssen die einzelnen Schichten in geeigneter Weise nacheinander aufgebracht werden, ohne dass es zu einer unerwünschten Überdeckung der Schichten kommt.

Aus der DE 10 2010 049 398 A1 ist eine verschleiß- und oxidationsbeständige Turbinenschaufel bekannt, die eine oxidationsbeständige, metallische Schicht umfasst, insbesondere eine MCrAlY - Schicht, wobei M ein Metall, insbesondere Nickel, Kobalt oder eine Kombination daraus ist, und die zusätzlich eine keramische Wärmedämmschicht aufweisen kann. Zusätzlich zu dieser oxidationsbeständigen Schutzschicht ist an der Schaufelspitze eine mittels Laserauftragsschweißen aufgebrachte Schutzschicht aus Abrasivmaterial und Bindematerial vorgesehen. Zunächst wird die oxidationsbeständige Schutzschicht in Form der MCrAlY - Schicht vollflächig auf die Schaufel aufgebracht. Die MCrAlY - Schicht wird im Bereich der Schaufelspitze wieder mechanisch entfernt und anschließend wird im Bereich der Schaufelspitze mittels Laserauftragsschweißen die verschleißbeständige Schutzschicht an der Schaufelspitze aufgebracht.

Dieses Verfahren ist sehr aufwändig und fehleranfällig, da beim Entfernen der oxidationsbeständigen Schutzschicht im Bereich der Schaufelspitze die Schutzschicht auch weitergehend beschädigt werden kann. Außerdem kann es beim Laserauftragsschweißen auch zu einer Beschädigung beziehungsweise Überdeckung der Oxidationsschutzschicht kommen.

JP10030403 offenbart eine Gasturbinenschaufelspitze (6) mit einer Panzerung aus Alumina-Partikeln (5) in galvanisch abgeschiedener Ni-Matrix (7). Darauf wird eine Ni-Legierung aufgebracht. Die NickelLegierung wird danach entfernt.

EP2316988 offenbart in der mittleren Figur in Abbildung 6, ein Zwischenprodukt, wobei alle Schichten auf der Schaufelspitze entfernt werden. Danach wird eine oxidationsbeständige Schicht mit einer cBN-Matrix auf die Schaufelspitze aufgebracht.

### OFFENBARUNG DER ERFINDUNG

### AUFGABE DER ERFINDUNG

Es ist somit Aufgabe der vorliegenden Erfindung ein Verfahren zur Herstellung einer Schaufel für eine Strömungsmaschine bereitzustellen, bei der in einfacher und zuverlässiger Weise mindestens zwei unterschiedliche Beschichtungen auf der Schaufel angeordnet werden können, ohne dass die Funktion und Qualität der einzelnen Beschichtungen gegenseitig beeinträchtigt wird. Insbesondere besteht die Aufgabe darin, für eine Schaufel einer Strömungsmaschine eine Schaufelspitzenpanzerung neben einer Erosionsschutzschicht in einer effizienten Weise aufzubringen, wobei die Erosionsschutzschicht insbesondere keine Überdeckung der Schaufelspitzenpanzerung und somit Beeinträchtigung der Funktionsweise der Schaufelspitzenpanzerung bewirken soll. Darüber hinaus ist es Aufgabe der vorliegenden Erfindung, eine entsprechende Schaufel für eine Strömungsmaschine, wie eine stationäre Gasturbine oder ein Flugtriebwerk, bereitzustellen.

### TECHNISCHE LÖSUNG

Die oben genannte Aufgabenstellung wird durch ein Verfahren mit den Merkmalen des Anspruchs 1 sowie eine Schaufel mit den Merkmalen des Anspruchs 9 gelöst. Vorteilhafte Ausgestaltungen sind Gegenstand der abhängigen Ansprüche.

Die Erfindung schlägt vor, bei einer Schaufel zunächst eine erste Beschichtung, insbesondere eine Schaufelspitzenpanzerung an der Schaufelspitze, aufzubringen und anschließend auf der ersten Beschichtung bzw. der aufgebrachten Schaufelspitzenpanzerung eine schlecht haftende Teilschicht abzuscheiden, die zu einem späteren Zeitpunkt dazu dient als Sollbruchstelle zu fungieren. Auf die erste Beschichtung oder Schaufelspitzenpanzerung mit der schlecht haftenden Teilschicht wird nämlich nach dem erfindungsgemäßen Verfahren eine zweite Beschichtung, nämlich im vorliegenden Fall die Erosionsschutzschicht, mit aufgebracht, wenn die zweite Schicht, also die Erosionsschutzschicht, in den dafür vorgesehenen Bereichen der Schaufel also beispielsweise am Schaufelblatt aufgebracht wird, sodass eine vollflächige Beschichtung der Schaufel mit der zweiten Beschichtung, also der Erosionsschutzschicht erfolgen kann, während die erste Beschichtung bzw. Schaufelspitzenpanzerung nur lokal begrenzt, also an der Schaufelspitze abgeschieden wird. Nachdem die Erosionsschutzschicht (zweite Beschichtung) dann vollflächig auf den Bereichen, auf denen die Erosionsschutzschicht vorzusehen ist, sowie auf dem Bereich der Schaufelspitzenpanzerung (erste Beschichtung) mit der schlecht haftenden Teilschicht aufgebracht ist, wird die Erosionsschutzschicht (zweite Beschichtung) im Bereich der Schaufelspitzenpanzerung (erste Beschichtung) wieder entfernt, wobei die schlecht haftende Teilschicht eine einfache Entfernung der Erosionsschutzschicht (zweite Beschichtung) ermöglicht.

Entsprechend kann unter schlecht haftend eine Haftung verstanden werden, die so gewählt wird, dass sie ausreichend groß ist, damit die schlecht haftenden Teilschicht nicht vor oder während der Abscheidung der Erosionsschutzschicht abgelöst wird, aber gleichzeitig möglichst klein ist, um eine einfache Ablösung der schlecht haftenden Teilschicht mit der darauf angeordneten Erosionsschutzschicht zu bewirken.

Eine Möglichkeit dafür, eine schlecht haftende Teilschicht zu realisieren, besteht darin, auf der Schaufelspitzenpanzerung zunächst eine dünne Oxidschicht zu erzeugen und auf dieser eine Metallschicht abzuscheiden, sodass die Metallschicht eine schlecht haftende Teilschicht darstellt, die eine schwache Haftung auf der Oxidschicht besitzt.

Eine entsprechende Oxidschicht kann elektrolytisch durch anodische Oxidation der Schaufelspitzenpanzerung erfolgen und/oder die schlecht haftende Teilschicht in Form einer Metallschicht kann durch galvanische Metallabscheidung erfolgen.

Dies ist besonders vorteilhaft, wenn die Schaufelspitzenpanzerung durch eine Metall - Matrix gebildet ist, die mit eingelagerten Hartstoffpartikeln versehen ist. Beispielsweise kann eine derartige Schaufelspitzenpanzerung aus einer Nickel - Matrix mit eingelagerten Partikeln aus Bornitrid, insbesondere kubischem Bornitrid bestehen. Eine derartige Schaufelspitzenpanzerung lässt sich einfach durch galvanisches Abscheiden einer Nickel - Matrix mit eingelagerten Hartstoffpartikeln erzeugen, wobei dann in einfacher Weise durch eine Umpolung im elektrolytischen Prozess eine Oxidschicht durch anodische Oxidation der Schaufelspitzenpanzerung erzeugt werden kann. Dazu muss die Schaufel, die während der galvanischen Abscheidung als Kathode geschaltet wird, lediglich zur Anode umgepolt werden, sodass die anodische Oxidation insbesondere der Nickel - Matrix der Schaufelspitzenpanzerung erfolgen kann. Entsprechend kann dann in einem weiteren Schritt durch eine erneute Umpolung der Schaufel wiederum galvanisch eine Nickelabscheidung erfolgen, sodass auf der durch die anodische Oxidation erzeugten Oxidschicht eine metallische Schicht bzw. Nickelschicht erzeugt wird, die jedoch auf der Oxidschicht schlecht haftet.

Auf der so vorbereiteten Schaufelspitzenpanzerung wird erfindungsgemäß die Erosionsschutzschicht zusätzlich zu den Bereichen, in denen die Erosionsschutzschicht eigentlich vorgesehen werden soll, abgeschieden. Die Abscheidung kann durch physikalische Dampfphasenabscheidung, insbesondere Aufdampfen, erfolgen und erfordert somit keine lokale Begrenzung der Abscheidung.

Vor der Abscheidung der Erosionsschutzschicht kann eine Reinigung der Schaufel erfolgen, beispielsweise durch Kathodenzerstäubung, wobei die bereits vorliegende Schaufelspitzenpanzerung mit der schlecht haftenden Teilschicht, beispielsweise in Form der auf der Oxidschicht abgeschiedenen Nickelschicht, so ausgebildet ist, dass die schlecht haftende Teilschicht während der Reinigung der Schaufel nicht abgelöst wird.

Die Ablösung der Erosionsschutzschicht von der Schaufelspitzenpanzerung nach Fertigstellung der Erosionsschutzschicht kann durch einfache mechanische Bearbeitung, beispielsweise beim Reinigen und/oder Glätten der aufgebrachten Erosionsschutzschicht durch Schleifen oder dergleichen erfolgen. Durch die schlecht haftende Teilschicht und die dadurch vorgegebene Sollbruchstelle im Schichtenverbund im Bereich der Schaufelspitzenpanzerung kommt es dort zu einer einfachen Ablösung der Erosionsschutzschicht mit der schlecht haftenden Teilschicht in Form einer Metallschicht.

Die Ablösung kann ganz oder teilweise auch erst beim ersten Betrieb der Schaufel erfolgen, da bereits bei einer geringfügigen mechanischen Belastung die Erosionsschutzschicht im Bereich der Schaufelspitzenpanzerung entfernt wird.

Entsprechend weist eine Schaufel für eine Strömungsmaschine mit einer Schaufelspitzenpanzerung und einer Erosionsschutzschicht, bei welcher die Schaufelspitzenpanzerung eine Metall - Matrix mit eingelagerten Hartstoffpartikeln umfasst, eine Oxidschicht auf, die auf der Metall - Matrix der Schaufelspitzenpanzerung angeordnet ist.

Die entsprechende Oxidschicht kann sehr dünn ausgeführt sein und insbesondere eine Dicke im Nanometerbereich aufweisen, also beispielsweise eine Dicke kleiner oder gleich 0,1 µm, vorzugsweise kleiner oder gleich 100 nm und insbesondere kleiner oder gleich 10 nm. Eine derartig dünne Oxidschicht kann im Betrieb, wenn die Schaufelspitze an dem gegenüberliegenden Dichtmaterial anschleift, schnell und leicht entfernt werden, sodass die Schaufelspitzenpanzerung ihre Funktion vollumfänglich erfüllen kann.

### KURZBESCHREIBUNG DER FIGUREN

Die beigefügten Zeichnungen zeigen in rein schematischer Weise in
- Figur 1: eine perspektivische Ansicht einer Schaufel, wie sie in Strömungsmaschinen eingesetzt werden kann und in
- Figur 2: in den Teilbildern a) bis f) einen Teil einer Turbinenschaufel nach den verschiedenen Verfahrensschritten.

### AUSFÜHRUNGSBEISPIELE

Weitere Vorteile, Kennzeichen und Merkmale der vorliegenden Erfindung werden bei der nachfolgenden detaillierten Beschreibung von Ausführungsbeispielen deutlich. Allerdings ist die Erfindung nicht auf diese Ausführungsbeispiele beschränkt.

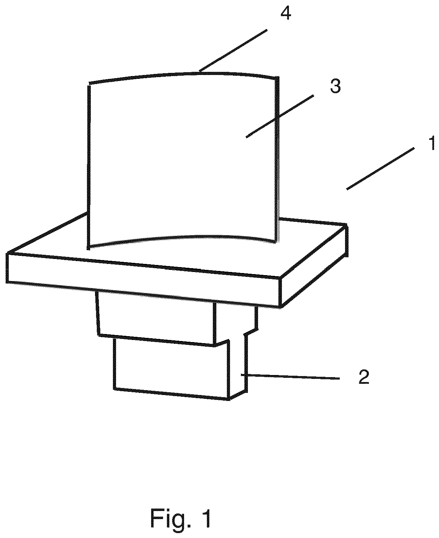

Die Figur 1 zeigt in einer rein schematischen Weise eine perspektivische Ansicht einer Schaufel, wie sie in einer Strömungsmaschine, wie beispielsweise einer stationären Gasturbine oder einem Flugtriebwerk eingesetzt werden kann. Die Schaufel 1 weist einen Schaufelfuß 2 auf, der in eine Scheibe eingesetzt werden kann, die mit einer Welle der Strömungsmaschine dreht. Die Schaufel 1 weist weiterhin ein Schaufelblatt 3 auf welches im Strömungskanal der Strömungsmaschine angeordnet ist und entweder das Fluid, das durch die Strömungsmaschine fließt, verdichtet oder durch das vorbeiströmende Fluid angetrieben wird. An dem radial außenliegenden Ende der Schaufel 1 befindet sich die sogenannte Schaufelspitze 4, die zur Vermeidung von Strömungsverlusten möglichst eng an einem umgebenden Strömungskanalgehäuse anliegt oder sich in dieses sogar einschleift. Zu diesem Zweck wird an der Schaufelspitze 4 eine Schaufelspitzenpanzerung vorgesehen, die auch eine Schneidfunktion aufweist, sodass sich die Schaufelspitze 4 in ein umgebendes Strömungskanalgehäuse beziehungsweise daran angeordnetes Dichtungsmaterial einschneiden kann. Beispielsweise kann die Schaufelspitzenpanzerung durch eine Beschichtung mit einer Nickel - Matrix mit eingelagerten kubischen Bornitrid - Partikeln gebildet sein.

Das Schaufelblatt 3 weist ebenfalls zum Schutz der Schaufel 1 eine Beschichtung auf, nämlich eine Erosionsschutzbeschichtung, die das Material der Schaufel 1 vor Erosionsverschleiß schützen soll. Eine derartige Erosionsschutzbeschichtung kann aus einer sogenannten Multi - Layer - Schicht beziehungsweise Mehrlagen - Schicht bestehen, die aus einer Vielzahl von alternierend abgeschiedenen harten und weichen Schichten, insbesondere Keramikschichten und Metallschichten, bestehen kann.

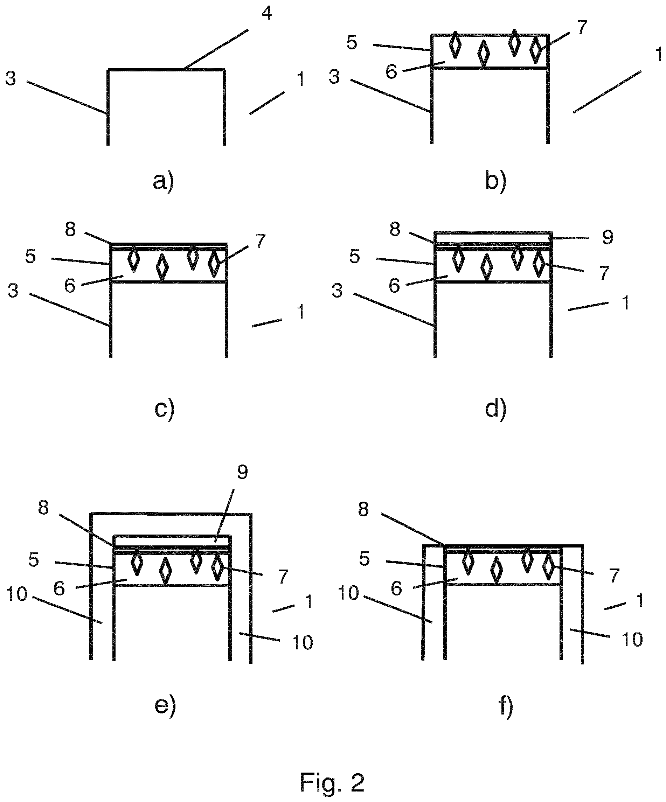

Die Figur 2 zeigt in den Teilbildern a) bis f) die verschiedenen Stadien bei der Herstellung einer Schaufel mit einer Schaufelspitzenpanzerung an der Schaufelspitze 4 und eine Erosionsschutzbeschichtung an dem Schaufelblatt 3. In Teilbild a) der Figur 2 ist ein Teil einer Schaufel 1 mit dem Schaufelblatt 3 und der Schaufelspitze 4 gezeigt.

Auf die Schaufelspitze 4 wird gemäß Figur 2 b) eine Schaufelspitzenpanzerung 5 aufgebracht, die aus einer Nickel - Matrix und darin eingelagerten Partikeln 7 aus kubischem Bornitrid besteht. Die Aufbringung der Schaufelspitzenpanzerung 5 erfolgt durch galvanische Abscheidung der Nickel - Matrix 6, in welche die kubischen Bornitrid - Partikel eingelagert werden.

Nachdem die Schaufelspitzenpanzerung 5 fertiggestellt ist, wird anstelle der kathodischen Abscheidung des Nickels die Elektrolyse so abgeändert, dass die Schaufel 1 als Anode geschaltet wird, sodass die Nickel - Matrix 6 anodisch oxidiert wird und sich eine dünne Oxidschicht 8 auf der Nickel - Matrix 6 bildet, die in dem Teilbild c) der Figur 2 zu sehen ist. Die Dicke der abgeschiedenen Oxidschicht liegt im Nanometerbereich und kann insbesondere kleiner oder gleich 0,1 µm, kleiner oder gleich 100 nm oder kleiner oder gleich 10 nm sein.

Nachdem die Elektrolyse in dem Elektrolysebad ausreichend lange betrieben worden ist, um eine ausreichend dicke Oxidschicht 8 herzustellen, wird die Schaufel 1 wieder als Kathode geschaltet, sodass sich wieder eine galvanische Abscheidung von Nickel ergibt. Somit wird oberhalb der Oxidschicht 8 eine weitere Nickel - Schicht 9 abgeschieden, die jedoch auf der Oxidschicht 8 eine schlechte Haftung aufweist. Die Dicke der Nickel - Schicht 9 kann ebenso wie die Dicke der Oxidschicht sehr klein sein und ebenfalls im Nanometerbereich liegen, beispielsweise kleiner oder gleich 0,1 µm.

Die so vorbereitete Schaufel 1, die in Teilbild d) der Figur 2 zu sehen ist, wird nun für die Aufbringung der Erosionsschutzschicht 10 vorbereitet, was bedeutet, dass die Abdeckung (nicht gezeigt) an dem Schaufelblatt 3, die dazu dient, dass keine galvanische Abscheidung und/oder anodische Oxidation außerhalb des Bereichs der Schaufelspitze 4 erfolgen kann, entfernt wird und die gesamte Schaufel 1 beziehungsweise zumindest die Bereiche, in denen die Erosionsschutzschicht vorgesehen werden soll, werden für die Abscheidung der Erosionsschutzschicht durch Reinigen vorbereitet. Das Reinigen kann z.B. durch Kathodenzerstäubung (sputtem) erfolgen. Die schlecht haftende Nickelschicht 9 auf der dünnen Oxidschicht 8 darf durch das Reinigungssputtern vor dem Aufbringen der Erosionsschutzschicht 10 nicht vollständig abgetragen werden. Entsprechend muss die Nickel - Schicht 9 so dick sein, dass sie das Reinigungssputtern vor dem Aufbringen der Erosionsschutzschicht übersteht.

Nach der Reinigung kann dann die Erosionsschutzschicht 10 durch physikalische Dampfphasenabscheidung (PVD physical vapor deposition) abgeschieden werden und zwar insbesondere durch Aufdampfen der entsprechenden Partialschichten der Multi - Layer - Erosionsschutzschicht. Dabei erfolgt eine vollflächige Beschichtung der Schaufel 1 sowohl am Schaufelblatt 3 als auch an der Schaufelspitze 4 oberhalb der Schaufelspitzenpanzerung 5, und zwar auf der Nickel - Schicht 9 (siehe Figur 2 e)).

Um die Schaufelspitzenpanzerung 5 wieder frei zu legen und um die Hartstoffpartikel, wie das kubische Bornitrid, beim Betrieb der Schaufel für das Einschleifen in ein gegenüberliegendes Dichtungsmaterial bereitzustellen, wird im Bereich der Schaufelspitzenpanzerung 5 die Erosionsschutzschicht 10 wieder entfernt, wobei durch die geringe Haftung der Nickel - Schicht 9 auf der Oxidschicht 8 die Entfernung der Nickel - Schicht 9 und der Erosionsschutzschicht 10 im Bereich der Schaufelspitzenpanzerung 5 in einfacher Weise leicht erfolgen kann. Die Entfernung der Erosionsschutzschicht 10 oberhalb der Schaufelspitzenpanzerung 5 kann durch einfache mechanische Verfahren, wie Schleifen oder dergleichen, erfolgen und kann insbesondere bereits in einem Reinigungsschritt, der nach der Abscheidung der Erosionsschutzschicht 10 durchgeführt werden kann, erfolgen, da aufgrund der geringen Haftung der Nickel - Schicht 9 auf der Oxidschicht 8 die Erosionsschutzschicht 10 im Bereich der Schaufelspitzenpanzerung 5 leicht entfernt werden kann.

Die Situation nach der Entfernung der Erosionsschutzschicht 10 im Bereich der Schaufelspitzenpanzerung 5 ist im Teilbild f) der Figur 2 dargestellt. Wie zu erkennen ist, befindet sich oberhalb der Nickel - Matrix 6 lediglich eine Oxidschicht 8, die beim Anschleifen der Schaufelspitzenpanzerung an einem gegenüberliegenden Dichtungsmaterial leicht entfernt werden kann, sodass die in der Nickel - Matrix 6 eingelagerten Partikel aus kubischen Bornitrid in einfacher Weise ihre Schneidfunktion erfüllen können.

Die Schaufelspitzenpanzerung 5 ist in die benachbarte Erosionsschutzschicht 10 eingebettet und wird von dieser umgeben, ohne die Schleiffläche der Schaufelspitzenpanzerung 5, die in Kontakt mit einem gegenüberliegenden Dichtungsmaterial gelangt, zu überdecken.

Obwohl die vorliegende Erfindung anhand der gezeigten Ausführungsbeispiele deutlich beschrieben worden ist, ist die Erfindung nicht auf diese Ausführungsbeispiele beschränkt, sondern vielmehr sind Abwandlungen in der Weise möglich, dass einzelne Merkmale weggelassen oder andersartige Kombinationen von Merkmalen verwirklicht werden können, solange der Schutzbereich der beigefügten Ansprüche nicht verlassen wird.

## Patentansprüche

1. Verfahren zur Herstellung einer Schaufel (1) für eine Strömungsmaschine, wobei die Schaufel an ihrer Schaufelspitze (4) eine Schaufelspitzenpanzerung (5) und zumindest an ihrem Schaufelblatt (3) eine Erosionsschutzschicht (10) aufweist,
**dadurch gekennzeichnet, dass**
zunächst eine Schaufelspitzenpanzerung an der Schaufelspitze aufgebracht wird, anschließend auf der Schaufelspitzenpanzerung eine schlecht haftende Teilschicht (9) abgeschieden wird, und nachfolgend auf der schlecht haftenden Teilschicht und dem Schaufelblatt die Erosionsschutzschicht (10) erzeugt wird, wobei die schlecht haftende Teilschicht zusammen mit der Erosionsschutzschicht im Bereich der Schaufelspitzenpanzerung nach Fertigstellung der Erosionsschutzschicht wieder entfernt wird, wobei die die schlecht haftende Teilschicht eine einfache Entfernung der Erosionsschutzschicht ermöglicht.

2. Verfahren nach Anspruch 1,
**dadurch gekennzeichnet, dass**
als schlecht haftende Teilschicht (9) eine Metallschicht auf einer zuvor auf der Schaufelspitzenpanzerung erzeugten Oxidschicht (8) abgeschieden wird.

3. Verfahren nach Anspruch 2,
**dadurch gekennzeichnet, dass**
die Oxidschicht (8) elektrolytisch durch anodische Oxidation der Schaufelspitzenpanzerung erfolgt.

4. Verfahren nach Anspruch 2 oder 3,
**dadurch gekennzeichnet, dass**
die schlecht haftende Teilschicht (9) durch galvanische Metallabscheidung, insbesondere galvanische Nickelabscheidung erzeugt wird.

5. Verfahren nach einem der vorhergehenden Ansprüche,
**dadurch gekennzeichnet, dass**
die Schaufelspitzenpanzerung (5) durch galvanisches Abscheiden einer Nickel - Matrix (6) mit eingelagerten Hartstoffpartikeln (7), insbesondere Partikeln aus Bornitrid erfolgt.

6. Verfahren nach einem der vorhergehenden Ansprüche,
**dadurch gekennzeichnet, dass**
die Erosionsschutzschicht (10) durch physikalische Dampfphasenabscheidung, insbesondere Aufdampfen abgeschieden wird.

7. Verfahren nach einem der vorhergehenden Ansprüche,
**dadurch gekennzeichnet, dass**
vor der Abscheidung der Erosionsschutzschicht (10) eine Reinigung der Schaufel, insbesondere durch Kathodenzerstäubung erfolgt.

8. Verfahren nach einem der vorhergehenden Ansprüche,
**dadurch gekennzeichnet, dass**
die auf der Schaufelspitzenpanzerung (5) abgeschiedene Erosionsschutzschicht (10) nach der Abscheidung der Erosionsschutzschicht mit der schlecht haftenden Teilschicht (9) mechanisch entfernt wird, insbesondere bei der Reinigung der Schaufel.

9. Schaufel für eine Strömungsmaschine, hergestellt mit einem Verfahren nach einem der vorhergehenden Ansprüche, wobei die Schaufel an ihrer Schaufelspitze (4) eine Schaufelspitzenpanzerung (5) und zumindest an ihrem Schaufelblatt (3) eine Erosionsschutzschicht (10) aufweist, und wobei die Schaufelspitzenpanzerung eine Metall - Matrix (6) mit eingelagerten Hartstoffpartikeln (7) umfasst,
**dadurch gekennzeichnet, dass**
auf der Metall - Matrix der Schaufelspitzenpanzerung eine Oxidschicht (S) angeordnet ist.

10. Schaufel nach Anspruch 9,
**dadurch gekennzeichnet, dass**
die Oxidschicht (8) eine Dicke kleiner oder gleich 0,1 µm, insbesondere kleiner oder gleich 50 nm, vorzugsweise kleiner oder gleich 10 nm aufweist.

11. Schaufel nach Anspruch 9 oder 10,
**dadurch gekennzeichnet, dass**
die Schaufelspitzenpanzerung (5) von der Erosionsschutzschicht (10) umgeben und/oder in dieser eingebettet ist.

## Claims

1. Method for producing a blade (1) for a turbomachine, the blade having, on the blade tip (4) thereof, blade tip cladding (5) and, at least on the airfoil portion (3) thereof, an anti-erosion layer (10),
**characterized in that**
blade tip cladding is initially applied on the blade tip, then a poorly adhering sublayer (9) is deposited on the blade tip cladding and the anti-erosion layer (10) is subsequently produced on the poorly adhering sublayer and the airfoil portion, the poorly adhering sublayer being removed again together with the anti-erosion layer in the region of the blade tip cladding after the anti-erosion layer has been completed, the poorly adhering sublayer making it possible to remove the anti-erosion layer in a simple manner.

2. Method according to claim 1,
**characterized in that**
a metal layer is deposited as the poorly adhering sublayer (9) on an oxide layer (8) that has been produced previously on the blade tip cladding.

3. Method according to claim 2,
**characterized in that**
the oxide layer (8) is created electrolytically by means of anodic oxidation of the blade tip cladding.

4. Method according to either claim 2 or claim 3,
**characterized in that**
the poorly adhering sublayer (9) is produced by means of galvanic metal deposition, in particular galvanic nickel deposition.

5. Method according to any of the preceding claims,
**characterized in that**
the blade tip cladding (5) is created by galvanically depositing a nickel matrix (6) that comprises incorporated hard material particles (7), in particular particles of boron nitride.

6. Method according to any of the preceding claims,
**characterized in that**
the anti-erosion layer (10) is deposited by means of physical vapor deposition, in particular thermal evaporation.

7. Method according to any of the preceding claims,
**characterized in that**
the blade is cleaned before the deposition of the anti-erosion layer (10), in particular by means of cathode sputtering.

8. Method according to any of the preceding claims,
**characterized in that**
the anti-erosion layer (10) deposited on the blade tip cladding (5) is mechanically removed together with the poorly adhering sublayer (9) after the deposition of the anti-erosion layer, in particular when the blade is cleaned.

9. Blade for a turbomachine, produced by means of a method according to any of the preceding claims, the blade having, on the blade tip (4) thereof, blade tip cladding (5) and, at least on the airfoil portion (3) thereof, an anti-erosion layer (10), and the blade tip cladding comprising a metal matrix (6) that comprises incorporated hard material particles (7), **characterized in that**
an oxide layer (8) is arranged on the metal matrix of the blade tip cladding.

10. Blade according to claim 9,
**characterized in that**
the oxide layer (8) has a thickness of less than or equal to 0.1 µm, in particular less than or equal to 50 nm, preferably less than or equal to 10 nm.

11. Blade according to either claim 9 or claim 10,
**characterized in that**
the blade tip cladding (5) is surrounded by the anti-erosion layer (10) and/or is embedded therein.

## Revendications

1. Procédé de fabrication d'une pelle (1) pour turbomachine, dans lequel la pelle présente, au niveau de son extrémité de pelle (4), un blindage d'extrémité de pelle (5) et, au moins au niveau de sa pale de pelle (3), une couche de protection anti-érosion (10),
**caractérisé en ce que**
un blindage d'extrémité de pelle est tout d'abord appliqué sur l'extrémité de pelle, une couche partielle de mauvaise adhérence (9) est ensuite déposée sur le blindage d'extrémité de pelle, puis la couche de protection anti-érosion (10) est produite sur la couche partielle de mauvaise adhérence et sur la pale de pelle, dans lequel la couche partielle de mauvaise adhérence est de nouveau retirée avec la couche de protection anti-érosion dans la zone du blindage d'extrémité de pelle après achèvement de la couche de protection anti-érosion, dans lequel la couche partielle de mauvaise adhérence permet un retrait facile de la couche de protection anti-érosion.

2. Procédé selon la revendication 1,
**caractérisé en ce que**
en tant que couche partielle de mauvaise adhérence (9), une couche métallique est déposée sur une couche d'oxyde (8) préalablement produite sur le blindage d'extrémité de pelle.

3. Procédé selon la revendication 2,
**caractérisé en ce que**
la couche d'oxyde (8) est formée par électrolyse au moyen d'une oxydation anodique du blindage d'extrémité de pelle.

4. Procédé selon la revendication 2 ou 3,
**caractérisé en ce que**
la couche partielle de mauvaise adhérence (9) est produite par dépôt galvanique de métal, en particulier par dépôt galvanique de nickel.

5. Procédé selon l'une quelconque des revendications précédentes,
**caractérisé en ce que**
le blindage d'extrémité de pelle (5) est formé par dépôt galvanique d'une matrice de nickel (6) avec des particules de matériau dur intégrées (7), en particulier des particules de nitrure de bore.

6. Procédé selon l'une quelconque des revendications précédentes,
**caractérisé en ce que**
la couche de protection anti-érosion (10) est déposée par dépôt physique en phase vapeur, en particulier par évaporation.

7. Procédé selon l'une quelconque des revendications précédentes,
**caractérisé en ce que**
avant le dépôt de la couche de protection anti-érosion (10), un nettoyage de la pelle est effectué, en particulier par pulvérisation cathodique.

8. Procédé selon l'une quelconque des revendications précédentes,
**caractérisé en ce que**
la couche de protection anti-érosion (10) déposée sur le blindage d'extrémité de pelle (5) est retirée mécaniquement avec la couche partielle de mauvaise adhérence (9) après le dépôt de la couche de protection anti-érosion, en particulier lors du nettoyage de la pelle.

9. Pelle pour turbomachine, fabriquée par un procédé selon l'une quelconque des revendications précédentes, dans laquelle la pelle présente, au niveau de son extrémité de pelle (4), un blindage d'extrémité de pelle (5) et, au moins au niveau de sa pale de pelle (3), une couche de protection anti-érosion (10), et dans laquelle le blindage d'extrémité de pelle comprend une matrice métallique (6) avec des particules de matériau dur intégrées (7),
**caractérisée en ce que**
une couche d'oxyde (8) est disposée sur la matrice métallique du blindage d'extrémité de pelle.

10. Pelle selon la revendication 9,
**caractérisée en ce que**
la couche d'oxyde (8) présente une épaisseur inférieure ou égale à 0,1 µm, en particulier inférieure ou égale à 50 nm, de préférence inférieure ou égale à 10 nm.

11. Pelle selon la revendication 9 ou 10,
**caractérisée en ce que**
le blindage d'extrémité de pelle (5) est entouré par la couche de protection anti-érosion (10) et/ou incorporé dans celle-ci.
